# EUROPÄISCHE PATENTSCHRIFT

(11) **EP 0 852 088 B1**
(45) Veröffentlichungstag und Bekanntmachung des Hinweises auf die Patenterteilung: **27.12.2000**
(21) Anmeldenummer: 96934410.0
(22) Anmeldetag: 03.09.1996
(51) Int. Cl.: H04L 1/00

(54) **VERFAHREN UND SCHALTUNGSANORDNUNG ZUR VERARBEITUNG VON NUTZDATEN**
PROCESS AND CIRCUIT FOR PROCESSING USEFUL DATA
PROCEDE ET CIRCUITERIE POUR LE TRAITEMENT DE DONNEES UTILES

(30) Priorität: 22.09.1995 DE 19535359
(43) Veröffentlichungstag der Anmeldung: 08.07.1998
(73) Patentinhaber: SIEMENS AKTIENGESELLSCHAFT, 80333 München (DE)
(72) Erfinder: RAAF, Bernhard, D-81475 München (DE)
(86) Internationale Anmeldenummer: DE9601638
(87) Internationale Veröffentlichungsnummer: WO9711542

(56) Entgegenhaltungen:
- EP-A- 0 627 821
- WO-A-92/12483
- GB-A- 2 216 752
- US-A- 4 541 093

## Beschreibung

Die Erfindung betrifft ein Verfahren und eine Schaltungsanordnung zur Verarbeitung von Nutzdaten nach dem Oberbegriff des Anspruchs 1 bzw. nach Anspruch 8.

In der Mobilfunktechnik nach dem Standard "Global System for Mobile Communications" (GSM) wird ein Verfahren zur Übertragung von Nutzdaten von einer sendeseitigen Einrichtung zu einer empfangsseitigen Einrichtung verwendet, bei dem sendeseitig die Nutzdaten redundant kodiert ("channel coding") und in einer "Interleaving"-Prozedur auf verschiedenen Datenpakete (bursts) verteilt werden. (Mouly, Michel; Pautet, Marie-Bernadette: The GSM System for Mobile Communications, ISBN: 2-9507190-0.) Empfangsseitig werden die übertragenen Datenpakete in einer "De-Interleaving-Prozedur" aufgelöst, wobei die Datenbits der Datenpakete entsprechend ihrer ursprünglichen Sequenz auf der Sendeseite wieder angeordnet werden. Anschließend werden die Nutzdaten dekodiert ("channel decoding"). Bei dem vorbekannten Verfahren werden empfangsseitig alle übertragenen Datenpakete dekodiert.

Ausgehend von diesem Stand der Technik liegt der Erfindung die Aufgabe zugrunde, ein Verfahren bzw. eine Schaltungsanordnung der eingangs genannten Art anzugeben, wobei das Verfahren weniger komplex ausgestaltet ist bzw. wobei die Schaltungsanordnung die Durchführung dieses Verfahrens ermöglicht.

Diese Aufgabe wird erfindungsgemäß durch ein Verfahren und eine Schaltungsanordnung gelöst, die in den Ansprüchen definiert sind.

Die Erfindung zeichnet sich durch den Vorteil aus, daß empfangsseitig der Rechenaufwand zur Demodulation der übertragenen Nutzdaten reduziert wird.

Ein weiterer Vorteil der Erfindung besteht darin, daß zugleich eine Reduzierung der für die Durchführung des entsprechenden Verfahrens erforderlichen elektrischen Leistung realisiert wird.

Das erfindungsgemäße Verfahren ist mit dem GSM-Standard kompatibel, so daß Kommunikationsverbindungen z.B. zwischen Mobilfunkendgeräten und Basisstationen unabhängig davon möglich sind, ob in einer empfangsseitigen Einrichtung dieser Geräte das erfindungsgemäße Verfahren zum Einsatz kommt.

Die Erfindung wird nun anhand der Zeichnungen beschrieben.

Es zeigt:
- Fig. 1: sendeseitigen Schritte im Zusammenhang mit dem erfindungsgemäßen Verfahren;
- Fig. 2: empfangsseitige Schritte des erfindungsgemäßen Verfahrens; und
- Fig. 3 und Fig. 4: die sendeseitige und empfangsseitige Schaltungsanordnung zur Durchführung des erfindungsgemäßen Verfahrens nach den Figuren 1 bzw. 2.

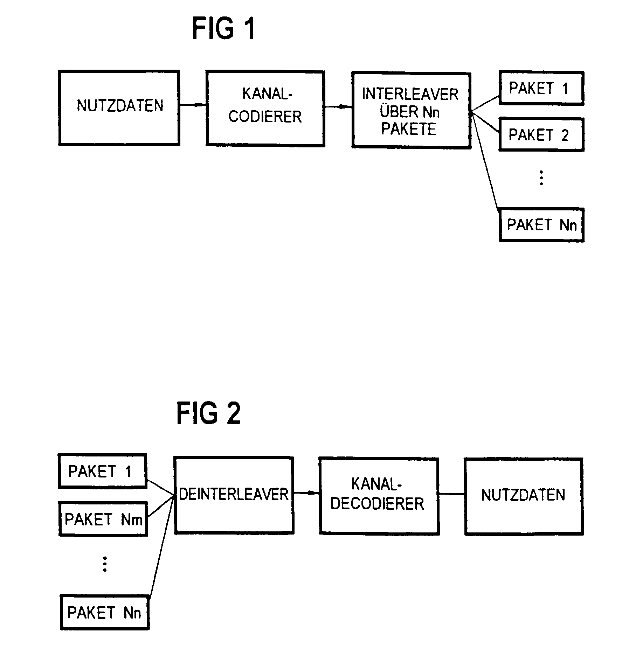

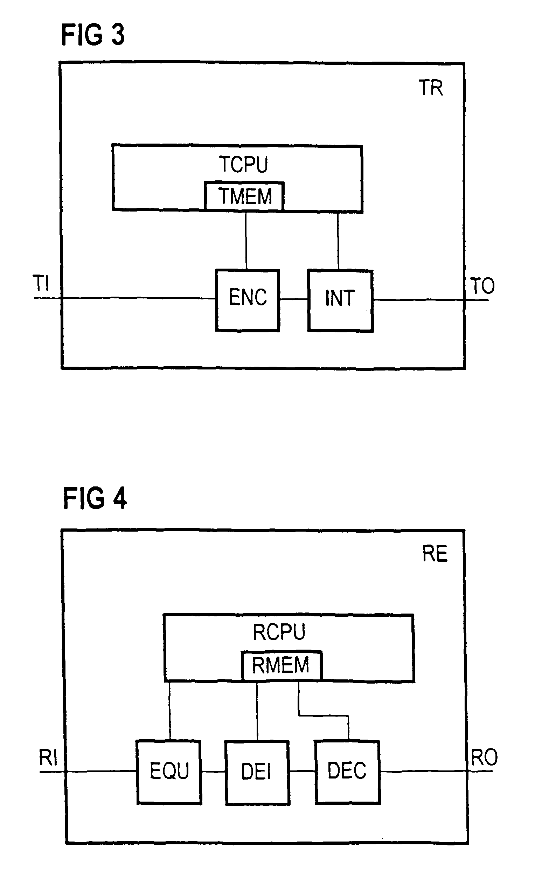

Eine sendeseitige Einrichtung TR (Fig. 3) führt die in Figur 1 dargestellten Verfahrensschritte durch. Der Einrichtung TR mit einem Eingang TI werden digitale Nutzdaten, z.B. digitalkodierte Sprachdaten oder sonstige digitalkodierte Fernmeldedaten bzw. Signalisierungsdaten eingegeben und einer Kanalkodiereinrichtung ENC zugeführt. Der Einrichtung TR können auch analoge Sprachdaten oder sonstige Fernmeldedaten zugeführt werden, die dann in einem nicht dargestellten A/D-Wandler digitalkodiert werden.

In der Kanalkodiereinrichtung ENC werden die Nutzdaten redundant kodiert. Die redundante Kodierung dient im Stand der Technik dazu, eine ausreichende Empfangsqualität auch bei einem Auftreten von Störungen sicherzustellen, wobei ermöglicht wird, Fehler zu erkennen und gegebenenfalls zu korrigieren. Erfindungsgemäß wird die redundante Kodierung jedoch noch in anderer Weise verwendet wie nachstehend beschrieben.

Ein Beispiel für eine redundante Kodierung ist die Verdoppelung eines jeden Nutzdatenbits, wobei die beiden identischen Bits, also das ursprüngliche Bit und das gedoppelte Bit, unmittelbar aufeinanderfolgend in der Nutzdatenbitfolge angeordnet werden.

Weitere Beispiele für derartige redundante Kodierverfahren sind sogenannte "Convolutional Codes" und "Block Codes".

Im Anschluß an die redundante Kanalkodierung wird die Nutzdatenbitfolge, d.h. jeweils eine vorgebbare Nutzdatenmenge, durch eine Interleaving-Einrichtung INT auf Nn Datenpakete in an sich bekannter Weise aufgeteilt und verpackt. Die Aufteilung der Nutzdatenbits auf die Nn Datenpakete erfolgt dabei in der Weise, daß in der redundant kodierten Nutzdatenbitfolge aufeinanderfolgende Bits, die dieselbe Information darstellen (z.B. ursprüngliches Nutzdatenbit und gedoppeltes Bit) auf unterschiedliche Datenpakete verteilt werden.

Im Anschluß an die Durchführung der vorstehend genannten Interleaving-Prozedur werden die Daten, gegebenenfalls nach einer Verschlüsselung, moduliert, dem Ausgang TO der sendeseitigen Einrichtung zugeführt und zu der empfangsseitigen Einrichtung RE übertragen. Ein Steuerwerk TCPU der sendeseitigen Einrichtung TR steuert die beschriebenen sendeseitigen Vorgänge in an sich bekannter Weise.

Diese Nn Datenpakete werden sukzessiv oder parallel über einen physikalischen Kanal übertragen.

Die übertragenen Datenpakete gelangen über den Eingang RI (Fig. 4) in die empfangsseitige Einrichtung RE, die die sendeseitigen in Figur 2 dargestellten Verfahrensschritte durchführt. Die übertragenen Datenpakete werden gegebenenfalls nach Entzerrung und Demodulation, die von einer Einrichtung EQU durchgeführt wird (Demodulator) und gegebenenfalls nach Entschlüsselung (ebenfalls durch EQU) der Einrichtung EQU, z.B. einem sogenannten Equalizer, zuführt.

Die Einrichtung EQU prüft für jedes empfangene Nutzdatenbit die Wahrscheinlichkeit, mit der dieses Bit eine "0" oder eine "1" repräsentiert. Dies kann beispielsweise mittels eines Schwellwertdetektors erfolgen, wobei geprüft wird, ob der Spannungswert des übertragenen Bits oberhalb bzw. unterhalb eines vorgebbaren Schwellwerts liegt, oder mittels eines an sich bekannten Viterbi-Algorithmus.

Für jedes Nutzdatenbit einer ersten Anzahl Nm (Nm kleiner als Nn) zunächst empfangener Datenpakete wird damit ein sogenannter Softdecisionwert (d.h. ein Wert für die Wahrscheinlichkeit, mit der ein Nutzdatenbit eine "0" oder eine "1" repräsentiert) gebildet.

Die in der Einrichtung EQU gebildeten Softdecisionwerte aller empfangenen Nutzdatenbits dieser Nm Datenpakete werden in einem Speicher RMEM abgespeichert. Erfindungsgemäß werden anstelle der tatsächlichen Softdecisionwerte nicht empfangener Nutzdatenbits Werte "ungültig" in dem Speicher RMEM abgespeichert. Die Bildung dieser Werte "ungültig" der nicht empfangenen Nutzdatenbits wird von dem Steuerwerk RCPU der empfangsseitigen Einrichtung RE gegebenenfalls im Zusammenwirken mit der De-Interleaving-Einrichtung und/oder der Dekodiereinrichtung DEC durchgeführt.

Die Softdecisionwerte der nicht empfangenen Nutzdatenbits werden also erfindungsgemäß auf den Wert "ungültig" gesetzt. Das "ungültig"-Setzen wird entweder in dem Speicher RMEM durchgeführt oder erfolgt bei dem Auslesen der Softdecisionwerte aus dem Speicher RMEM, wobei die Folge der Softdecisionwerte der empfangenen Nutzdatenbits und die Werte "ungültig" (für jedes nicht empfangene Nutzdatenbit) der Dekodiereinrichtung DEI oder bereits der De-Interleaving-Einrichtung DEI zugeführt wird. Der Wert "ungültig" bezeichnet sonst die geringste Übertragungsqualität.

Im Anschluß an die Demodulation (durch eine nicht dargestellte Demodulationseinrichtung) und Bildung der vorstehend genannten Softdecisionwerte werden nach einer Ausführungsform des erfindungsgemäßen Verfahrens die empfangenen Nutzdatenpakete bzw. deren Softwertdecisionwerte sowie die Werte "ungültig" (für jedes nicht empfangene Nutzdatenbit) der De-Interleaving-Einrichtung DEI zugeführt. Diese Einrichtung DEI löst die Datenpakete in an sich bekannter Weise auf (De-Interleaving-Prozedur) und stellt die Nutzdatenbitfolge her, die sendeseitig von der Kanalkodiereinrichtung ENC generiert wurde, wobei gegebenenfalls nicht die empfangenen Nutzdatenbits selbst, sondern deren Softdecisionwerte in dieser Abfolge angeordnet werden.

Aus den unterschiedlichen Datenpaketen werden also die Nutzdatenbits herausgelöst und zu der ursprünglichen Nutzdatenbitfolge in Form der Softdecisionwerte verbunden, so daß ursprünglich (sendeseitig vor der Einrichtung INT) aufeinanderfolgende Bits wieder aufeinanderfolgend angeordnet sind.

Der Dekodiereinrichtung DEC werden nach der De-Interleaving-Prozedur die Softdecisionwerte der Nutzdatenbits der Nm Datenpakete und zusätzlich die auf ungültig gesetzten Softdecisionwerte der nicht empfangenen Datenpakete (Nm+1, ..., Nn) zugeführt. Im Rahmen der Erfindung kann eine im Stand der Technik verwendete Dekodiereinrichtung DEC unverändert benutzt werden. Im Stand der Technik werden dieser Dekodiereinrichtung Softdecisionwerte aller übertragener Nutzdatenbits zugeführt. Abgesehen von dieser aufwendigen Verarbeitung ergeben sich Probleme, wenn zwei oder mehr redundante Nutzdatenbits unterschiedliche Softdecisionwerte aufweisen. Dabei können sich Erkennungsfehler ergeben und die Empfangsqualität verschlechtert werden.

Erfindungsgemäß kann die gesendete Information wegen der redundanten Kodierung bereits dann rekonstruiert werden, wenn noch nicht alle Datenpakete empfangen bzw. demoduliert worden sind, sondern nur die ersten Nm Pakete. Das Nutzdatenpaket Nm ist dasjenige Nutzdatenpaket, nach dessen Empfang erfindungsgemäß bereits die sendeseitige Dekodierung begonnen wird.

Empfangsseitig kann auch erst in der Dekodiereinrichtung DEC durch einen entsprechenden Dekodieralgorithmus jedes empfangene kodierte Nutzdatenbit (also aller Nutzdatenpakete (1 ..., Nm, ..., Nn)) bzw. deren Softdecisionwerte darauf überprüft werden, ob es auf Grund seiner Position in der Signalfolge zu einem weiteren Nutzdatenpaket Nₘ₊₁, ..., Nm gehört.

Ergibt sich bei dieser Überprüfung, daß Nutzdatenbits bzw. deren Softdecisionwerte zu einem weiteren Paket Nₘ₊₁, ..., Nm gehören, werden diese Nutzdatenbits bzw. deren Softdecisionwerte nicht auf den Wert "ungültig" gesetzt und in an sich bekannter Weise dekodiert.

Erfindungsgemäß kann auch ein Dekodieralgorithmus für den Betrieb vorgesehen werden, gemäß dem nur die ersten Nm Pakete bei der Dekodierung berücksichtigt werden. Nach dem Empfang der Nm Datenpakete wird die empfangsseitige Einrichtung RE abgeschaltet, beziehungsweise wird die Einrichtung DEI und/oder EQU deaktiviert. Ebenso wird die eigentliche, der Einrichtung EQU vorgeschaltete, nicht dargestellte Empfangseinrichtung (HF-Teil) abgeschaltet.

Erfindungsgemäß wird also bereits nach dem Empfang einer vorgebbaren Anzahl Nm erster Datenpakete der entsprechenden Nutzdatenmenge mit der Dekodierung der Nutzdaten (channel decoding) begonnen. Die Dekodierung erfolgt durch die Einrichtung DEC. Die Anzahl der Datenpakete, nach deren Empfang bereits mit der Dekodierung begonnen wird, beträgt also Nm. Diese Anzahl ist kleiner als die Anzahl Nn der sendeseitig aus einer vorgegebenen Nutzdatenmenge gebildeten Datenpakete.

Damit stehen am Ausgang RO der sendeseitigen Einrichtung RE die dekodierten Daten für eine Wiedergabe bzw. für eine Weiterverarbeitung zur Verfügung. Zugleich reduziert sich der empfangsseitig zu leistende Rechenaufwand, da nur ein Teil, nämlich die Anzahl Nm erster Datenpakete empfangen, demoduliert, gegebenenfalls entzerrt, entschlüsselt und dekodiert werden, wobei die restlichen Datenpakete der Nutzdatenmenge, d.h. die Datenpakete Nₘ₊₁, ..., N keiner Verarbeitung unterzogen werden.

Erfindungsgemäß ist ferner vorgesehen, daß empfangsseitig aus den Softdecisionwerten der ersten Datenpaketen Nm eine Information abgeleitet wird, die eine Abschätzung ermöglicht, ob die Dekodierung der ersten Nm Datenpakete ausreichend ist. Hierzu veranlaßt das Steuerwerk RCPU der empfangsseitigen Einrichtung RE, daß die von der Einrichtung EQU gebildeten Softdecisionwerte in den Speicher RMEM übertragen werden.

Liegen beispielsweise alle Softdecisionwerte über einem bestimmten Schwellwert, so wird angenommen, daß die Verwendung der ersten Nm Datenpakete ausreichend ist, und das Steuerwerk RCPU bildet eine entsprechende Information.

Die Datenpakete Nₘ₊₁, ..., Nm werden nur dann dekodiert, sofern die vorstehend genannte Information die Abschätzung ermöglicht, daß die Dekodierung der ersten Nm Datenpakete nicht ausreichend ist. Unabhängig kann auch vorgesehen werden, daß die dekodierten Daten der ersten Nm Datenpakete darauf überprüft werden, ob die Dekodierung der ersten Datenpakete Nm ausreichend war. Hierzu greift das Steuerwerk auf die von der Einrichtung DEC gebildeten Daten zu und nimmt die Überprüfung vor.

Ergibt diese Überprüfung, daß die Dekodierung der ersten Nm Datenpakete nicht ausreichend war, werden auch die Nutzdaten der weiteren Datenpakete Nm+1, ..., Nm empfangen und in an sich bekannter Weise dekodiert.

Nach der Dekodierung (channel decoding) erfolgt gegebenenfalls die Quellendekodierung und schließlich die Digital-Analogwandlung (nicht dargestellter D/A-Wandler). Die digitalen bzw. analogen Nutzdaten stehen damit einer Weiterverarbeitung (z.B. Abspeicherung) bzw. Wiedergabe (akustisch, optisch) am Ausgang RO der empfangsseitigen Einrichtung zur Verfügung.

Die sendeseitige Einrichtung TR und die empfangsseitige Einrichtung RE weisen jeweils ein Steuerwerk TCPU, RCPU auf. Jedem Steuerwerk ist ein Steuerungsprogramm zugeordnet, das das erfindungsgemäße Verfahren, mindestens soweit es die sendeseitigen oder die empfangsseitigen Schritte betrifft, definiert.

In der erfindungsgemäßen empfangsseitigen Einrichtung RE ist wie bereits beschrieben neben dem genannten Steuerwerk RCPU ein Speicher RMEM für die Aufnahme der Softdecisionwerte vorgesehen.

Die Erfindung ist vorzugsweise für Mobiltelefone einsetzbar. Hierauf ist die Anwendung der Erfindung jedoch nicht beschränkt.

## Patentansprüche

1. Verfahren zur Verarbeitung von Nutzdaten, die von einer sendeseitigen Einrichtung zu einer empfangsseitigen Einrichtung übertragen werden, wobei
a) sendeseitig die Nutzdaten redundant kodiert werden,
b) sendeseitig eine Folge von Nutzdatenbits einer vorgebbaren Nutzdatenmenge auf Nn unterschiedliche Datenpakete verteilt werden,
c) die Nutzdaten in den Datenpaketen übertragen werden,
d) empfangsseitig die Datenpakete aufgelöst werden und die ursprüngliche Folge von Nutzdatenbits wiederhergestellt wird,
e) empfangsseitig die Nutzdaten dekodiert werden, und wobei
f) empfangsseitig Nutzdaten nur einer vorgebbaren Anzahl (Nm) erster Datenpakete, welche Anzahl (Nm) kleiner ist als die Anzahl (Nn) sendeseitig gebildeter Datenpakete, dekodiert werden und aus den dekodierten Nutzdaten die sendeseitig vorliegende Nutzdatenmenge wiederhergestellt wird,
**dadurch gekennzeichnet,**
daß
g) empfangsseitig Softdecisionwerte, die den Bits der weiteren sendeseitig gebildeten Datenpaketen (Nm + 1, ..., Nm) zugeordnet sind und einen Wert für die Wahrscheinlichkeit angeben, mit der ein Nutzdatenbit eine "0" oder eine "1" repräsentiert, vor ihrer Dekodierung auf den Wert "ungültig" gesetzt werden.

2. Verfahren nach Anspruch 1, dadurch gekennzeichnet, daß empfangsseitig bei einer erfolglosen Dekodierung der Nutzdaten der ersten Datenpakete (Nm) Nutzdaten der weiteren sendeseitig gebildeten und dann übertragenen Datenpakete (Nm + 1, ..., Nm) dekodiert werden.

3. Verfahren nach Anspruch 1 oder 2, dadurch gekennzeichnet, daß empfangsseitig aus den ersten Datenpaketen (Nm) eine Information abgeleitet wird, die eine Abschätzung ermöglicht, ob die Dekodierung der Nutzdaten der ersten Datenpakete (Nm) hinsichtlich der Wiederherstellung der Nutzdatenmenge ausreichend ist.

4. Verfahren nach Anspruch 3, dadurch gekennzeichnet, daß empfangsseitig Softdecisionwerte, die den Bits der weiteren sendeseitig gebildeten Datenpaketen (Nm + 1, ..., Nm) zugeordnet sind, vor der Durchführung der De-Interleaving-Prozedur auf den Wert "ungültig" gesetzt werden.

5. Verfahren nach Anspruch 3 oder 4, dadurch gekennzeichnet, daß die Softdecisionwerte in einer Speichereinrichtung (RMEM) auf den Wert "ungültig" gesetzt werden.

6. Verfahren nach Anspruch 3 oder 4, dadurch gekennzeichnet, daß die Softdecisionwerte in einer Speichereinrichtung (RMEM) abgespeichert werden und bei ihrem Auslesen aus der Speichereinrichtung (RMEM) auf den Wert "ungültig" gesetzt werden.

## Claims

1. Method for processing user data which are transmitted from a transmit-end device to a receive-end device,
a) the user data being coded with redundancy at the transmit end,
b) a sequence of user data bits of a predefinable quantity of user data being distributed at the transmit end between Nn different data packets,
c) the user data being transmitted in the data packets,
d) the data packets being broken up at the receive end and the original sequence of user data bits being restored,
e) the user data being decoded at the receive end, and
f) user data of only a predefinable number (Nm) of first data packets, which number (Nm) is smaller than the number (Nn) of data packets which are formed at the transmit end, being decoded at the receive end and the quantity of user data which are present at the transmit end being recovered from the decoded user data,
characterized in that
g) soft decision values which are assigned to the bits of the further data packets (Nm + 1, ..., Nm) which are formed at the transmit end and which specify a value for the probability with which a user data bit represents a "0" or a "1" are set to the value "invalid" at the receive end before their decoding.

2. Method according to Claim 1, characterized in that user data of the further data packets (Nm + 1, ..., Nm) which are formed at the transmit end and then transmitted are decoded at the receive end in the event of unsuccessful decoding of the user data of the first data packets (Nm).

3. Method according to Claim 1 or 2, characterized in that an item of information which makes it possible to estimate whether the decoding of the user data of the first data packets (Nm) is sufficient in terms of recovering the quantity of user data is derived from the first data packets (Nm) at the receive end.

4. Method according to Claim 3, characterized in that soft decision values which are assigned to the bits of the further data packets (Nm + 1, ..., Nm) which are formed at the transmit end are set to the value "invalid" at the receive end before the execution of the de-interleaving procedure.

5. Method according to Claim 3 or 4, characterized in that the soft decision values are set to the value "invalid" in a memory device (RMEM).

6. Method according to Claim 3 or 4, characterized in that the soft decision values are stored in a memory device (RMEM) and are set to the value "invalid" when they are read out of the memory device (RMEM).

## Revendications

1. Procédé pour le traitement de données utiles, qui sont transmises d'un dispositif côté émission à un dispositif côté réception,
a) les données utiles étant codées d'une façon redondante du côté émission,
b) une séquence de bits de données utiles d'un ensemble prédéterminé de données utiles étant répartie du côté émission sur Nn paquets de données différents,
c) les données utiles étant transportées dans les paquets de données,
d) les paquets de données étant ouverts côté réception et la séquence originale des bits de données utiles y étant reconstituée,
e) les données utiles étant décodées côté réception et
f) des données utiles étant décodées, côté réception, seulement en un nombre (Nm) de premiers paquets de données, qui peut être prédéterminé, ce nombre (Nm) étant inférieur au nombre (Nn) de paquets de données formés côté émission, et l'ensemble des données utiles qui existait côté émission étant reconstitué à partir des données utiles décodées,
**caractérisé par le fait**
que
g) côté réception, des valeurs de décision pondérée, qui sont attribuées aux bits des autres paquets de données formés côté émission (Nm + 1, ..., Nm) et qui fournissent une valeur pour la probabilité avec laquelle un bit de donnée utile représente un "0" ou un "1", sont assignées, avant leur décodage, à la valeur "non valable".

2. Procédé selon la revendication 1 caractérisé par le fait que, côté réception, lors d'un décodage infructueux des données utiles des premiers paquets de données (Nm), les données utiles des autres paquets formés côté émission, puis transportés (Nm + 1, ..., Nm), sont décodées.

3. Procédé selon la revendication 1 ou 2 caractérisé par le fait que, côté réception, une information est déduite des premiers paquets de données (Nm), laquelle permet d'apprécier si le décodage des données utiles des premiers paquets de données (Nm) est suffisant pour rétablir l'ensemble des données utiles.

4. Procédé selon la revendication 3 caractérisé par le fait que, côté réception, des valeurs de décision pondérée, qui sont attribuées aux bits des autres paquets de données formés côté émission (Nm + 1, ..., Nm), sont assignées à la valeur "non valable" avant l'exécution de la procédure de désentrelacement.

5. Procédé selon la revendication 3 ou 4 caractérisé par le fait que les valeurs de décision pondérée sont assignées, dans un dispositif de mémorisation (RMEM), à la valeur "non valable".

6. Procédé selon la revendication 3 ou 4 caractérisé par le fait que les valeurs de décision pondérée sont enregistrées dans un dispositif de mémorisation (RMEM) et sont, lors de leur lecture dans le dispositif de mémorisation (RMEM), assignées à la valeur "non valable".
